## Europäisches Patentamt

## European Patent Office

## Office européen des brevets

(19)

(11) **EP 0 995 199 B1**

(12) **EUROPÄISCHE PATENTSCHRIFT**

(45) Veröffentlichungstag und Bekanntmachung des Hinweises auf die Patenterteilung:
**21.08.2002   Patentblatt 2002/34**

(21) Anmeldenummer: **98937547.2**

(22) Anmeldetag: **25.06.1998**

(51) Int Cl.⁷: **H01B 5/14**

(86) Internationale Anmeldenummer:
**PCT/EP98/03894**

(87) Internationale Veröffentlichungsnummer:
**WO 99/003111 (21.01.1999 Gazette 1999/03)**

(54) **ELEKTRISCHE VORRICHTUNG, ELEKTRISCHES GERÄT BZW. BELEUCHTUNGSVORRICHTUNG**

ELECTRICAL DEVICE, ELECTRICAL APPLIANCE OR LIGHTING DEVICE

DISPOSITIF ELECTRIQUE, APPAREIL ELECTRIQUE ET DISPOSITIF D'ECLAIRAGE

(84) Benannte Vertragsstaaten:
**AT CH DE DK ES FI FR GB IT LI LU NL PT SE**
Benannte Erstreckungsstaaten:
**LT LV**

(30) Priorität: **08.07.1997   DE 29711973 U**

(43) Veröffentlichungstag der Anmeldung:
**26.04.2000   Patentblatt 2000/17**

(73) Patentinhaber: **Glas Platz**
**51580 Reichshof (DE)**

(72) Erfinder: **PLATZ, Karl-Otto**
**D-51746 Wiehl (DE)**

(74) Vertreter: **Dallmeyer, Georg, Dipl.-Ing. et al**
**Patentanwälte**
**Von Kreisler-Selting-Werner**
**Bahnhofsvorplatz 1 (Deichmannhaus)**
**50667 Köln (DE)**

(56) Entgegenhaltungen:
**DE-A- 4 134 836          DE-U- 9 215 662**

• **PATENT ABSTRACTS OF JAPAN vol. 95, no. 10, 30. November 1995 & JP 07 173610 A (AGENCY OF IND SCIENCE & TECHNOL), 11. Juli 1995**

**Beschreibung**

Die Erfindung betrifft eine elektrische Vorrichtung nach dem Oberbegriff des Anspruchs 1.

Bekannte Leiteranordnungen bestehen beispielsweise aus metallischen Stoffen, die den elektrischen Strom zu dem jeweiligen Verbraucher leiten. Es handelt sich hierbei in den meisten Fällen um isolierte oder nicht isolierte Kabel, die beispielsweise aus Kupfer oder anderen leitenden Materialien bestehen.

Vor allem in der Beleuchtungstechnik und dabei insbesondere bei der Innenraumbeleuchtung besitzt die Kabelzuführung zum Verbraucher hin verschiedene Nachteile. So kann sie unästhetisch und störend wirken, und den Gesamteindruck der Beleuchtungseinrichtung und des Innenraums nachteilig beeinflussen.

Um dieses Problem zu lösen, gibt es verschiedene Möglichkeiten. So ist es bei Tisch- oder Stehlampen üblich, die Kabelzuführung durch eine Ummantelung aus Metall oder Kunststoff abzudecken. Bei Innenraumbeleuchtungen werden die Kabel z.B. unter Putz verlegt, um sie dem Auge des Betrachters zu entziehen. Auch ist es inzwischen üblich, die Kabelzuführung selbst, wie z.B. bei den sogenannten Halogen-Schienen- oder Seilsystemen, als Dekorationsobjekt zu nutzen.

Alle diese Lösungen sehen jedoch nicht eine Kabelzuführung vor, die auf einfache Weise eine "unsichtbare Stromversorgung" des Verbrauchers, wie z.B. einer Lampe, ermöglichen.

Aus der Kraftfahrzeugtechnik ist es bereits bekannt, transparente, leitende Schichten auf Glas anzubringen, um auf diese Weise eine heizbare Heck- und/oder Frontscheibe herzustellen. In diesem Falle erfolgt die elektrische Stromzufuhr jedoch über eine herkömmliche Kabelzuführung und das Glas mit der aufgebrachten transparenten, leitenden Schicht stellt in dem Stromkreis den Verbraucher selbst dar, der einen möglichst hohen elektrischen Widerstand aufweisen muß, damit der Strom, in die für die Erwärmung der Scheibe notwendige Wärme umgesetzt werden kann.

Aus der JP-A-07173610 ist eine transparente elektrisch leitende ultradünne Filmschicht bekannt, die gegen Umwelteinflüsse resistent sein soll. Diese ultradünne Filmschicht kann auf einem Trägermaterial aus Glas aufgebracht sein. Die ultradünne Filmschicht ist als Elektrodenmaterial in Flüssigkristallanzeigevorrichtungen, als Heizelement gegen Beschlagen, z.B. in Kraftfahrzeug-Rückspiegeln, oder zur antistatischen Beschichtung von Kathodenstrahlröhren verwendbar.

Der Erfindung liegt die Aufgabe zugrunde, eine elektrische Vorrichtung, ein elektrisches Gerät bzw. eine Beleuchtungsvorrichtung derart weiterzubilden, daß auf einfache und kostengünstige Weise eine nicht sichtbare Stromzufuhr zu einem Verbraucher möglich ist.

Zur Lösung dieser Aufgabe dienen die Merkmale des Anspruchs 1.

Dadurch, daß die Leiteranordnung aus einem oder mehreren nicht-leitenden Trägermaterialien besteht, die mindestens eine transparente, leitende und leistungsübertragende Schicht aufweisen, ist eine Stromeinspeisung zu einem oder mehreren Verbrauchern auf unauffällige und einfache Weise ermöglicht. Die transparente, leitende Schicht sollte dabei eine Schichtquerschnittsfläche $A_{sch}$ und einen spezifischen Widerstand $\delta_{sch}$ aufweisen, die eine möglichst hohe Leistungsübertragung ermöglichen. Ein Verhältnis $\delta_{sch}/A_{sch} < 0,4$ Ohm/mm, vorzugsweise $< 0,3$ Ohm/mm, hat sich dabei als vorteilhaft-erwiesen.

Auf diese Weise ist es möglich, daß ein Stromverbraucher, z.B. eine Lampe, dann an einem freien Ende einer völlig transparenten Glaskonstruktion, wenn als Trägermaterial Glas eingesetzt wird, angebracht werden und ohne weitere Kabelzuführung betrieben werden kann. Dabei können mehrere leitende Schichten elektrisch gekoppelt auf einem oder mehreren Trägermaterialien aufgebracht sein. Auf diese Weise ist es möglich, je nach Anforderung leistungsstarke elektrische Vorrichtungen oder auch besonders einfach konstruierte und geringe Abmessungen aufweisende elektrische Vorrichtungen zu schaffen. Auch können bei derartigen elektrischen Vorrichtungen die Trägermaterialien unterschiedlich, wie z. B. aus Holz und Glas ausgeführt sein, um die elektrische Vorrichtung so gut wie möglich an bestimmte Raumgegebenheiten anzupassen.

Die Leiteranordnung der erfindungsgemäßen Vorrichtung dient jedoch der Stromeinspeisung zu einem Verbraucher, wobei der Leistungsverlust (sprich: Wärme) so gering wie möglich sein soll.

Als besonders geeignetes Trägermaterial hinsichtlich der Anwendung, aber auch hinsichtlich des Aufbringens der transparenten, leitenden Schicht hat sich Glas erwiesen.

Die transparente, leitende Schicht kann aus einer Metallschicht, wie z.B. Kupfer, Silber oder auch Gold, oder aus einer Metalloxidschicht, wie z.B. ITO (Indium-Zinn-Oxid), bestehen.

Um eine erhöhte Leistungsübertragung zu ermöglichen, ist es vorteilhaft, daß eine Anzahl transparenter leitender Schichten, jeweils getrennt durch eine transparente Isolationsschicht auf dem nicht-leitenden Trägermaterial angeordnet sind. Die abwechselnd aufgebrachten Schichten sind transparenter als eine dicke transparente leitende Schicht. Eine derartige Anordnung läßt sich wie eine sogenannte Multilayer-Platine verwenden, wobei mehrere Verbraucher getrennt mit Strom versorgt werden können.

Eine andere Möglichkeit der Leistungserhöhung oder der getrennten Versorgung von Verbrauchern mit Strom kann dadurch erreicht werden, daß eine Anzahl nicht-leitender Trägermaterialien mit transparenten, leitenden Schichten übereinander angeordnet sind. Auf diese Weise werden die leitenden Schichten berührungssicher in einer Art Verbundanordnung angeordnet, wodurch bei Verwendung von Glas als Trägermaterial einerseits eine gute Transparenz der Leiteranordnung gegeben ist und andererseits die Konstruktion der Leiteranordnung eine hohe Stabilität aufweist. Dadurch, daß die Trägermaterialien zueinander verschiebbar angeordnet sind, kann der Einsatzbereich der Leiteranordnung auf einfache Weise an die Anforderungen des Nutzers angepaßt werden. Wenn die transparenten, leitenden Schichten dann noch einander zugewandt auf den jeweiligen Trägermaterialien angebracht sind, ist durch ein Verschieben der Trägermaterialien relativ zueinander eine Leistungsregelung auf einfache Weise möglich.

Dadurch, daß das Verhältnis des spezifischen Widerstandes zum Flächenquerschnitt der leitenden Schichten gegenüber herkömmlichen Leitern, wie z.B. Kupferkabeln, relativ groß ist, ist der Gesamtwiderstand der Leiteranordnung (R = $\frac{\delta x L}{A}$) in hohem Maße auch von der Länge der leitenden Schichten abhängig. Diese Abhängigkeit kann bei einer elektrischen Vorrichtung vorteilhaft genutzt werden, wenn der Verbraucher verschiebbar auf der Leiteranordnung angeordnet ist. Bei einer entsprechenden Auslegung der Leiteranordnung kann dann eine Leistungsregelung durch eine Verschiebung des Verbrauchers stattfinden.

Im folgenden wird unter Bezugnahme auf die Zeichnungen ein Ausführungsbeispiel der Erfindung näher erläutert.

Es zeigen:

Fig. 1    eine Seitenansicht einer ersten Ausführungsform einer Leiteranordnung der erfindungsgemäßen Vorrichtung,

Fig. 2    eine Draufsicht auf die Leiteranordnung aus Fig. 1,

Fig. 3    eine Seitenansicht einer zweiten Ausführungsform der Leiteranordnung,

Fig. 4    eine Seitenansicht einer dritten Ausführungsform der Leiteranordnung, und

Fig. 5    eine Seitenansicht einer erfindungsgemäßen Beleuchtungsvorrichtung.

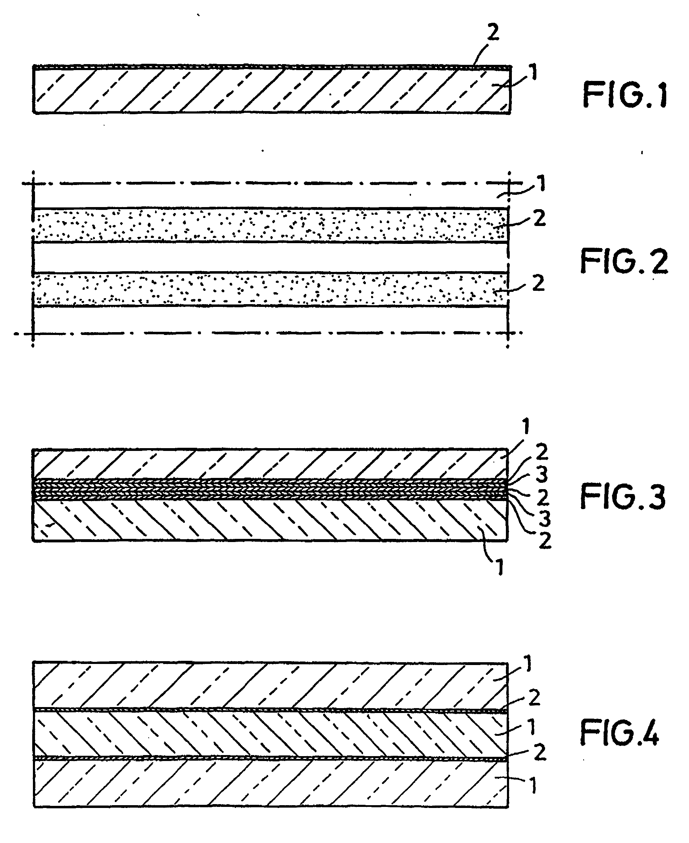

Fig. 1 zeigt eine Leiteranordnung in einer Seitenansicht. Auf einem Trägermaterial 1, im vorliegenden Falle Glas, ist eine transparente, leitende Schicht 2 aufgebracht. Diese transparente, leitende Schicht kann eine Metallschicht, wie z. B. aus Zinn, Zink, Silber, Titan, Eisen, Chrom, Kobalt oder auch Aluminium sein, die Schicht kann jedoch auch aus einer Metalloxidschicht bestehen, wie z. B. ITO (Indium-Zinn-Oxid), oder auch aus Kadmium-Zinn-Oxid. Im vorliegenden Fall handelt es sich um eine ITO-Schicht. Diese Schicht 2 wird auf bekannte Weise durch Bedampfen, Sprühen, Vaporisieren oder Sputtern auf das Trägermaterial aufgebracht.

Die hier verwendete ITO-Schicht besitzt einen spezifischen Widerstand $\delta_{sch}$ von 0,007 Ohm.mm. Die aufzubringende Schichtdicke $d_{sch}$ beträgt 350 nm. Die Breite $b_{sch}$ beträgt 50 mm und die Länge $l_{sch}$ der transparenten, leitenden Schicht beträgt 400 mm.

Daraus folgt:

$$A_{sch} = d_{sch} \cdot b_{sch} = 0,0175 \text{ mm}^2$$

$$\frac{\delta}{A_{sch}} = 0,4 \text{ Ohm/mm}$$

$$R_{sch} = \frac{\delta_{sch}}{A_{sch}} \times 1 = 160 \text{ Ohm (pro transparente leitende Schicht)}$$

Bei zwei leitenden Schichten: $R_{schGesamt}$ = 320 Ohm.

Für eine Glühbirne von 20 Watt und einen Widerstand von 2.420 Ohm bei einer Spannung von 220 Volt berechnet sich der durch die Leiteranordnung fließende Strom I wie folgt:

$$I = \frac{U}{R_{Gesamt}}$$

$$R_{Gesamt} = R_V + R_{schGesamt} = 2.420 \text{ Ohm} + 320 \text{ Ohm} = 2.740 \text{ Ohm.}$$

Daraus folgt $I = \frac{220\ V}{2.740\ Ohm} = 0{,}08$ A.

Messungen haben ergeben, daß bei einem Strom von I = 0,08 A die Erwärmung der Leiteranordnung < 2 °C ist. Es ist jedoch auch möglich, Ströme von max. ca. 1 A je Leiter zu übertragen, ohne, daß im Vergleich zu bekannten Beleuchtungsvorrichtungen eine übermäßige Erhitzung des Leiters verursacht wird.

Es sollte deutlich sein, daß bei einem kleineren Verhältnis von δ/A als 0,4 Ohm/mm auch die Erwärmung der Leiteranordnung geringer ist. Auf diese Weise ist es möglich, auch wesentlich höhere Leistungen durch die erfindungsgemäße Leiteranordnung zu übertragen, ohne daß sich die Leiteranordnung unzulässig erwärmt.

Fig. 2 zeigt die Leiteranordnung der Fig. 1 mit dem Trägermaterial 1 aus Glas und den transparenten, leitenden Schichten 2 in einer Draufsicht. Damit kann ein Stromkreislauf für einen Verbraucher durch eine derartige Leiteranordnung gebildet werden, wobei beispielsweise eine Spannungsquelle an dem einen Ende der Leiteranordnung angebracht ist und ein Verbraucher an dem anderen Ende zwischen den beiden transparenten, leitenden Schichten angebracht ist. Die eine transparente, leitende Schicht kann dann als Hinleitung und die andere als Rückleitung angesehen werden.

Es besteht jedoch auch die Möglichkeit, daß beide transparente, leitende Schichten als Hin- oder Rückleitung genutzt werden. Es ist erkennbar, daß auf diese Weise eine höhere Leistungsübertragung möglich ist.

Fig. 3 zeigt in einer Seitenansicht eine alternative Ausführungsform der Leiteranordnung. Bei dieser Ausführungsform wird auf dem Trägermaterial 1 eine transparente, leitende Schicht 2 angebracht und auf dieser Schicht 2 eine sogenannte Isolationsschicht 3 aufgebracht. Auch diese Isolationsschicht 3 kann transparent sein und aufgedampft werden. Zur Leistungserhöhung können im Wechselspiel mehrere transparente, leitende Schichten und Isolationsschichten übereinander angeordnet sein.

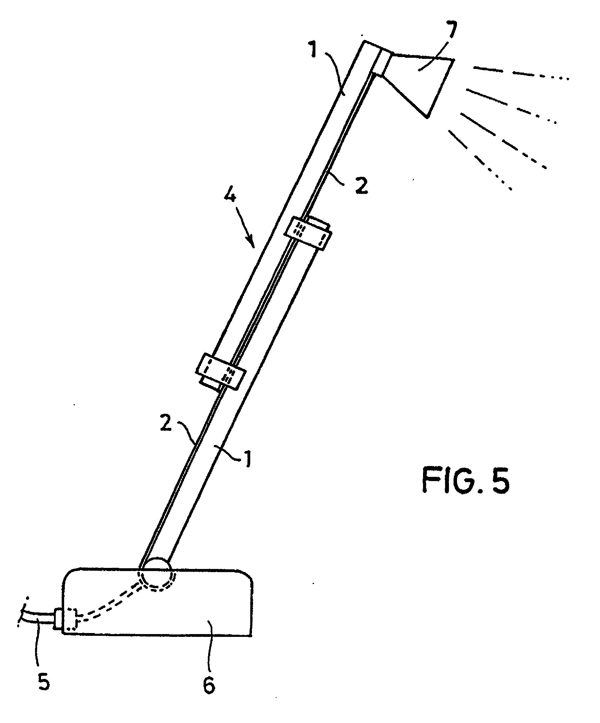

Fig. 4 zeigt eine weitere Ausführungsform der Leiteranordnung. Hierbei besteht die Leiteranordnung aus einer Verbundanordnung, wobei zwischen zwei Trägermaterialien 1 jeweils eine transparente Schicht 2 angeordnet ist. Diese Ausführungsmöglichkeit besitzt den Vorteil einer besonders hohen Stabilität.

Fig. 5 zeigt in einer Seitenansicht eine elektrische Vorrichtung, in diesem Fall eine Beleuchtungsvorrichtung 4, mit der erfindungsgemäßen Leiteranordnung. Die Beleuchtungsvorrichtung 4 ist über eine Kabelzuführung 5 auf bekannte Weise mit einer nicht dargestellten Spannungsquelle verbunden. Die Kabelzuführung 5 endet in dem Sockelelement 6, auf dem die Leiteranordnung schwenkbar angeordnet ist. Die Leiteranordnung besteht aus zwei Trägermaterialien 1 auf denen transparente, leitende Schichten 2 zueinander gerichtet aufgebracht sind. Die Trägermaterialien 1 mit den transparenten, leitenden Schichten 2 sind zueinander verschiebbar, wodurch eine Leistungsregelung möglich ist. An dem von dem Sockelelement 6 abgewandten Ende der Leiteranordnung ist ein Verbraucher 7, in diesem Fall eine Glühlampe, angebracht. Auch dieser Verbraucher kann verschiebbar auf der Leiteranordnung angeordnet sein, um eine Leistungsregelung zu ermöglichen.

Es versteht sich, daß sämtliche Arten von Lampen mit der beschriebenen Leiteranordnung betrieben werden können. Vorteilhafte Anwendungen sind überall dort zu finden, wo aus ästhetischen Gründen Stromkabel nicht sichtbar sein sollen, z.B. eine dritte Bremsleuchte (LED) in der Heckscheibe eines Fahrzeugs oder LED-Beleuchtungs- oder Anzeigeeinrichtungen in elektrischen Haushaltsgeräten.

**Patentansprüche**

**1.** Elektrische Vorrichtung (4) mit einem Stromanschluß, und mit einer Leiteranordnung aus einem nicht-leitenden Trägermaterial (1) mit mindestens einer transparenten elektrisch leitenden Schicht (2),
**dadurch gekennzeichnet,**
**daß** mindestens eine mit Strom zu versorgende Einrichtung (7) über die Leiteranordnung mit dem Stromanschluß verbunden ist, und
**daß** die transparente elektrisch leitende Schicht (2) mit einer Schichtquerschnittsfläche $A_{sch}$ und einem spezifischen Widerstand $\delta_{sch}$ ein Verhältnis von $\delta_{sch}/A_{sch} \leq 0{,}4$ Ohm/mm, vorzugsweise $\leq 0{,}3$ Ohm/mm, aufweist.

**2.** Vorrichtung nach Anspruch 1, **dadurch gekennzeichnet, daß** die mit Strom zu versorgende Einrichtung aus einer Lampe (7) besteht.

**3.** Vorrichtung nach einem der Ansprüche 1 oder 2, **dadurch gekennzeichnet, daß** das Trägermaterial (1) Glas ist.

**4.** Vorrichtung nach einem der Ansprüche 1 bis 3, **dadurch gekennzeichnet, daß** die transparente, leitende Schicht (2) eine Metall- oder Metalloxidschicht ist.

**5.** Vorrichtung nach einem der Ansprüche 1 bis 4, **dadurch gekennzeichnet, daß** die transparente leitende Schicht (2) eine Schichtdicke von 350 nm aufweist.

**6.** Vorrichtung nach einem der Ansprüche 1 bis 5, **dadurch gekennzeichnet, daß** eine Anzahl transparenter, leitender Schichten (2), jeweils voneinander getrennt durch eine transparente Isolationsschicht (3) auf dem nicht-leitenden Trägermaterial (1) angeordnet ist.

**7.** Vorrichtung nach einem der Ansprüche 1 bis 6, **dadurch gekennzeichnet, daß** eine Anzahl nicht-leitender Trägermaterialien (1) mit transparenten, leitenden Schichten (2) übereinander angeordnet sind.

**8.** Vorrichtung nach Anspruch 7, **dadurch gekennzeichnet, daß** die Trägermaterialien (1) zueinander verschiebbar angeordnet sind.

**9.** Vorrichtung nach Anspruch 7 oder 8, **dadurch gekennzeichnet, daß** die transparenten, leitenden Schichten (2) einander zugewandt auf den Trägermaterialien angeordnet sind und miteinander in Kontakt stehen.

**10.** Vorrichtung nach einem der Ansprüche 1 bis 9, **dadurch gekennzeichnet, daß** die stromabnehmende Einrichtung (7) verschiebbar auf der Leiteranordnung (1,2) angeordnet ist.

**Claims**

**1.** An electric device (4) comprising a current terminal and a conductor arrangement consisting of a non-conductive carrier material (1) with at least one transparent electrically conductive layer (2),
**characterized in that**
at least one means (7) to be supplied with current is connected to the current terminal via the conductor arrangement, and
the transparent electrically conductive layer (2) comprises a cross-sectional area of $A_{sch}$ and a specific resistance of $\delta_{sch}$, wherein the ratio is $\delta_{sch}/A_{sch} \leq 0.4$ ohms/mm, preferably $\leq 0.3$ ohms/mm.

**2.** The device according to claim 1, **characterized in that** the means to be supplied with current is a lamp (7).

**3.** The device according to any one of claims 1 or 2, **characterized in that** the carrier material (1) is glass.

**4.** The device according to any one of claims 1 to 3, **characterized in that** the transparent, conductive layer (2) is a metal or metal oxide layer.

**5.** The device according to any one of claims 1 to 4, **characterized in that** the transparent conductive layer (2) has a thickness of 350 nm.

**6.** The device according to any one of claims 1 to 5, **characterized in that** a number of transparent, conductive layers (2) are arranged on the non-conductive carrier material (1), each separated from one another by a transparent insulation layer (3).

**7.** The device according to any one of claims 1 to 6, **characterized in that** a number of non-conductive carrier materials (1) and transparent, conductive layers (2) are arranged on top of one another.

**8.** The device according to claim 7, **characterized in that** the carrier materials (1) are adapted to be shifted relative to one another.

**9.** The device according to claim 7 or 8, **characterized in that** the transparent conductive layers (2) are arranged on the carrier materials facing each other and in contact with each other.

**10.** The device according to any one of claims 1 to 9, **characterized in that** the current-consuming means (7) is arranged to be slidably shifted on the conductor arrangement (1, 2).

**Revendications**

**1.** Dispositif électrique (4) comportant un raccordement électrique et un aménagement conducteur constitué d'un matériau support (1) non conducteur avec au moins une couche (2) transparente conductrice de l'électricité,

**caractérisé par le fait qu'**au moins un dispositif (7) à alimenter avec du courant est relié par l'aménagement conducteur au raccordement électrique, et que la couche (2) transparente conductrice de l'électricité, ayant une superficie de section de couche $A_{sch}$ et une résistivité $\delta_{sch}$, présente un rapport $\delta_{sch}/A_{sch} \leq 0,4$ Ohm/mm, de préférence $\leq 0,3$ Ohm/mm.

2. Dispositif selon la revendication 1, **caractérisé par le fait que** le dispositif à alimenter en courant se compose d'une lampe (7).

3. Dispositif selon la revendication 1 ou 2, **caractérisé par le fait que** le matériau support (1) est du verre.

4. Dispositif selon l'une des revendications 1 à 3, **caractérisé par le fait que** la couche (2) transparente conductrice est une couche de métal ou d'oxyde métallique.

5. Dispositif selon l'une des revendications 1 à 4, **caractérisé par le fait que** la couche (2) transparente conductrice présente une épaisseur de couche de 350 nm.

6. Dispositif selon l'une des revendications 1 à 5, **caractérisé par le fait que** plusieurs couches (2) transparentes conductrices, séparées respectivement l'une de l'autre par une couche d'isolation (3) transparente, sont disposées sur le matériau support (1) non conducteur.

7. Dispositif selon l'une des revendications 1 à 6, **caractérisé par le fait que** plusieurs matériaux supports (1) non conducteurs avec leurs couches (2) transparentes conductrices sont disposés l'un sur l'autre.

8. Dispositif selon la revendication 7, **caractérisé par le fait que** les matériaux supports (1) sont disposés de manière coulissante l'un par rapport à l'autre.

9. Dispositif selon la revendication 7 ou 8, **caractérisé par le fait que** les couches (2) transparentes conductrices sont disposées tournées l'une vers l'autre sur les matériaux supports et se trouvent en contact l'une avec l'autre.

10. Dispositif selon l'une des revendications 1 à 9, **caractérisé par le fait que** le dispositif (7) recevant le courant est monté coulissant sur l'aménagement conducteur (1, 2).

FIG.1

FIG.2

FIG.3

FIG.4

FIG. 5